# EUROPEAN PATENT APPLICATION

(11) **EP 4 535 581 A1**
(43) Date of publication of application: **09.04.2025**
(21) Application number: 23811889.7
(22) Date of filing: 25.05.2023
(51) Int. Cl.: H01S 5/02253, H01S 5/02208

(54) **LASER DEVICE AND PACKAGE FOR MOUNTING OPTICAL COMPONENT**

(30) Priority: 27.05.2022 JP 2022086571
(71) Applicant: Kyocera Corporation, Kyoto-shi, Kyoto 612-8501 (JP)
(72) Inventor: NIINO Noritaka, Kyoto-shi, Kyoto 612-8501 (JP)
(74) Representative: Viering, Jentschura & Partner mbB Patent- und Rechtsanwälte
(86) International application number: PCT/JP2023/019557
(87) International publication number: WO 2023/229017

(57) **Abstract**

A laser device includes a package (100) including a base (110) and a lens (130), and a laser oscillator (150) accommodated in the package (100). The base (110) includes a first recess (112) and a mount surface (125) of a surface mounting type, the laser oscillator (150) is accommodated in the first recess (112), the lens (130) is bonded to the base (110) and seals the first recess (112), and the laser oscillator (150) emits laser light that exits the package (100) through the lens (130).

## Description

### TECHNICAL FIELD

The present disclosure relates to a laser device and a package equipped with an optical component.

### BACKGROUND OF INVENTION

Japanese Unexamined Patent Application Publication No. 2022-021419 discloses a laser device including a laser oscillator accommodated in a package and a collimator lens configured to transform laser beams emitted from the laser device to parallel beams.

### SUMMARY

### SOLUTION TO PROBLEM

According to the present disclosure, a laser device includes a package and a laser oscillator. The package includes a base and a lens. The laser oscillator is accommodated in the package. The base includes a first recess and a mount surface of a surface mounting type. The laser oscillator is accommodated in the first recess. The lens is bonded to the base and seals the first recess. The laser oscillator emits laser light that exits the package through the lens.

According to the present disclosure, a package equipped with an optical component includes a base and a lens. The base includes a first recess and a mount surface of a surface mounting type, and includes an optical component equipped portion disposed in the first recess. The lens is configured to seal the first recess when the lens is bonded to the base.

### BRIEF DESCRIPTION OF THE DRAWINGS

FIG. 1 is a perspective view of a laser device and a package equipped with an optical component according to embodiment 1 of the present disclosure.
FIG. 2 is an exploded perspective view of the package equipped with an optical component illustrated in FIG. 1.
FIG. 3 is a plan view of the laser device illustrated in FIG. 1.
FIG. 4A is a sectional view taken along line A-A in FIG. 1.
FIG. 4B is a sectional view taken along line B-B in FIG. 1.
FIG. 4C is a sectional view taken along line B-B in FIG. 1 according to a variation.
FIG. 5 is an enlarged view detailing a portion C1 in FIG. 4A.
FIG. 6A is a longitudinal sectional view of a laser device and a package equipped with an optical component according to embodiment 2.
FIG. 6B is an enlarged view detailing a portion C2 in FIG. 6A according to a first example.
FIG. 6C is an enlarged view detailing the portion C2 in FIG. 6A according to a second example.
FIG. 7 is a longitudinal sectional view of a laser device and a package equipped with an optical component according to embodiment 3.
FIG. 8 is a perspective view of a laser device and a package equipped with an optical component according to embodiment 4.
FIG. 9 is a sectional view taken along line D-D in FIG. 8.
FIG. 10A is a perspective view of a laser device and a package equipped with an optical component according to embodiment 5.
FIG. 10B is a perspective view of a laser device and a package equipped with an optical component according to embodiment 6.
FIG. 11A is a perspective view of a laser device and a package equipped with an optical component according to embodiment 7.
FIG. 11B is a perspective view of a laser device and a package equipped with an optical component according to embodiment 8.
FIG. 12A is a longitudinal sectional view of a laser device and a package equipped with an optical component according to embodiment 9.
FIG. 12B is an enlarged view detailing a portion C3 in FIG. 12A.
FIG. 13A is a longitudinal sectional view of a laser device and a package equipped with an optical component according to embodiment 10.
FIG. 13B is an enlarged view detailing a portion C4 in FIG. 13A.

### DESCRIPTION OF EMBODIMENTS

Embodiments of the present disclosure will be described in detail hereinafter with reference to the drawings.

### (Embodiment 1)

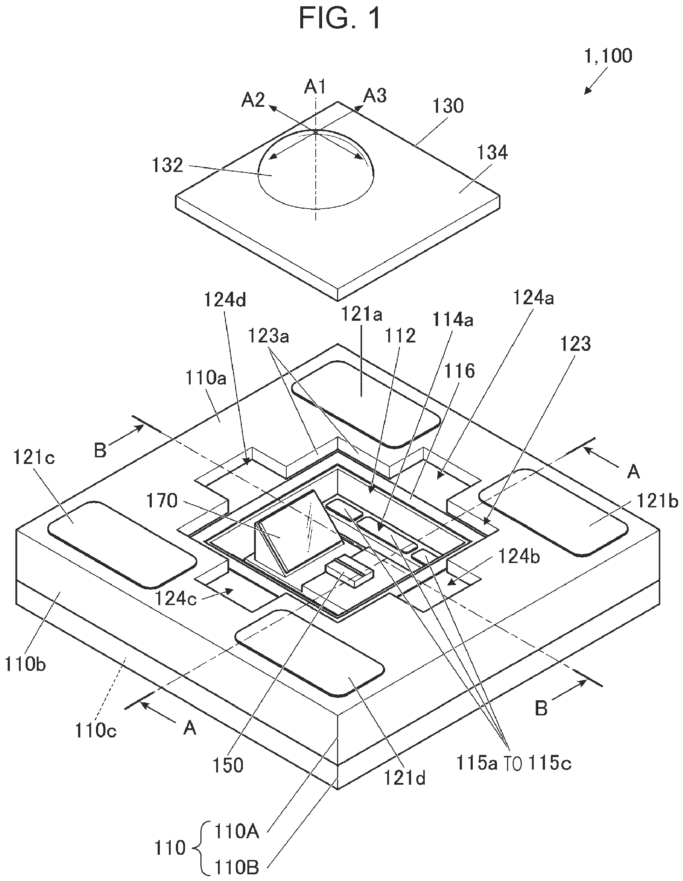

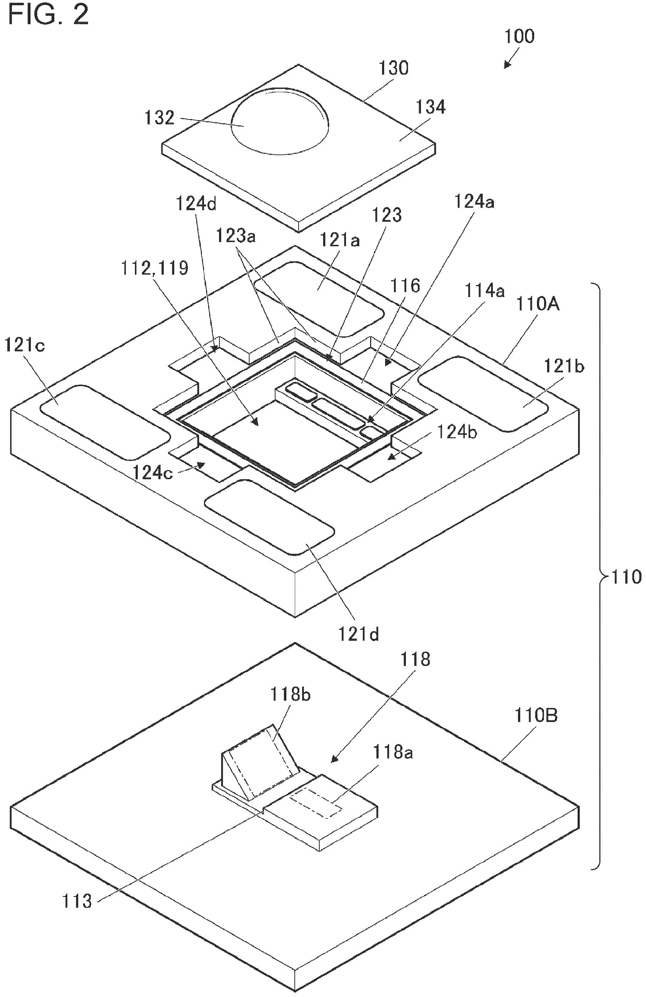

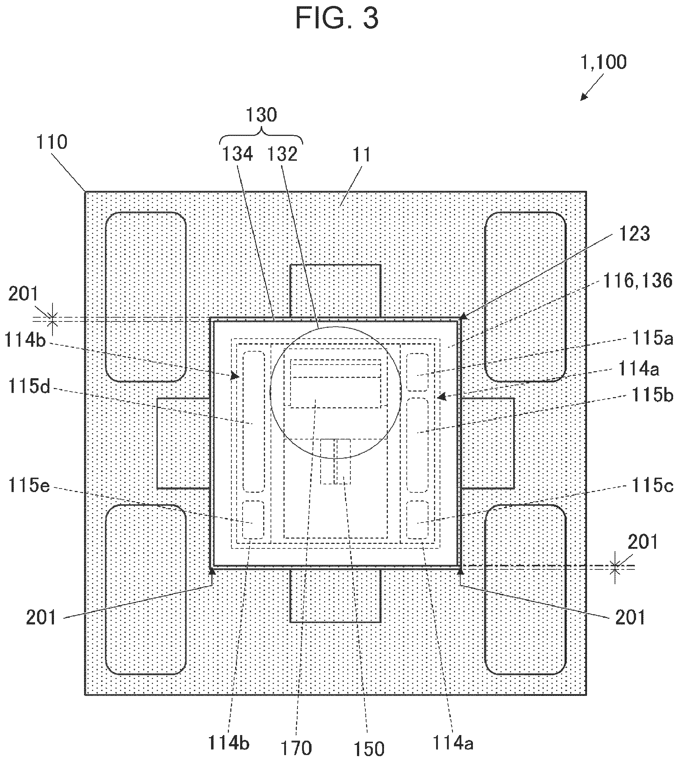

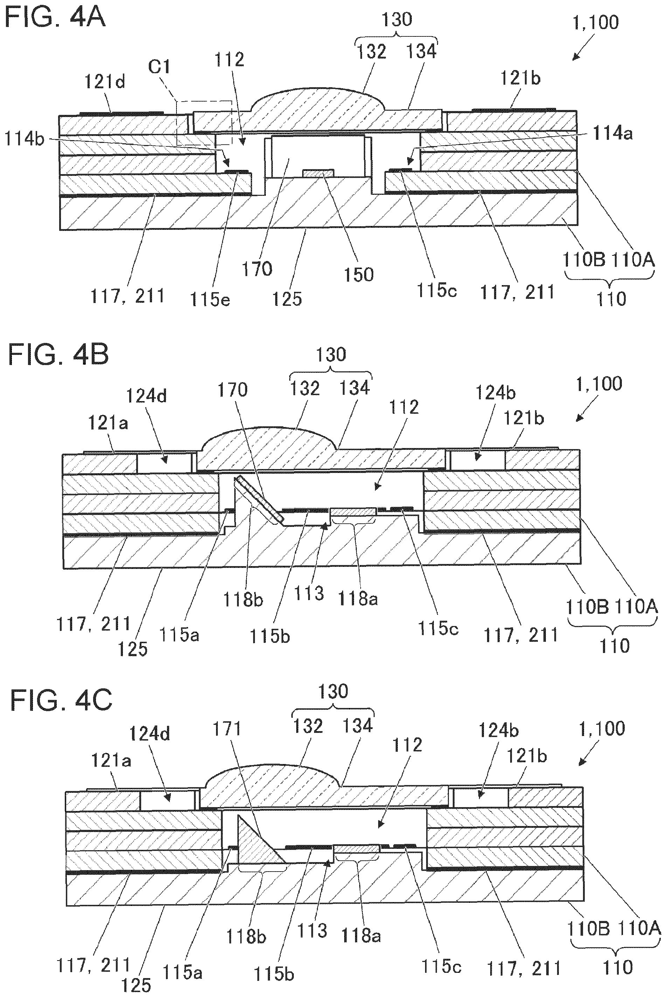

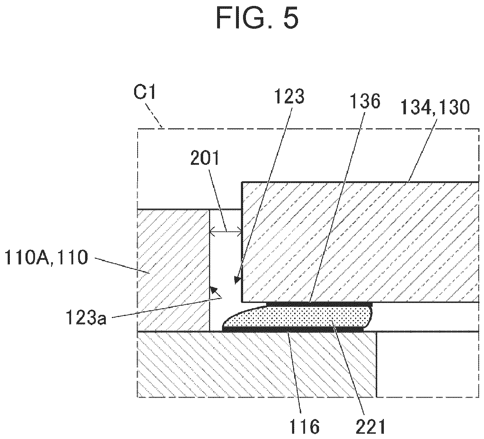

FIG. 1 is a perspective view of a laser device and a package equipped with an optical component according to embodiment 1 of the present disclosure. FIG. 2 is an exploded perspective view of the package equipped with an optical component illustrated in FIG. 1. FIG. 3 is a plan view of the laser device illustrated in FIG. 1. FIG. 4A is a sectional view taken along line A-A in FIG. 1. FIG. 4B is a sectional view taken along line B-B in FIG. 1. FIG. 4C is a sectional view taken along line B-B in FIG. 1 according to a variation. FIG. 5 is an enlarged view detailing a portion C1 in FIG. 4A.

According to embodiment 1 of the present disclosure, a laser device 1 includes a package (corresponding to a package equipped with an optical component) 100 including a base 110 and a lens 130, and a laser oscillator (corresponding to an optical component) 150 accommodated in the package 100. The base 110 may include a first recess 112 and a mount surface 125 (see FIG. 4A) of a surface mounting type.

The base 110 may include an upper surface 110a, a side surface 110b, and a lower surface 110c (see FIG. 1) to have a block shape. The base 110 has a minimum width in a horizontal direction, and the minimum width may be larger than a length in a height direction. The minimum width means a minimum interval between two vertical surfaces that are parallel to each other and interpose the base 110.

The mount surface 125 (see FIG. 4A) of the surface mounting type means a mount surface that is mountable at a site provided with no through-hole in a module substrate (not illustrated) mounting the laser device 1. The mount surface 125 of the surface mounting type may include no rod-shaped lead (specifically, a rod-shaped lead extending perpendicularly to the mount surface 125). The mount surface 125 of the surface mounting type may include a mount surface facing an electrode pad of the module substrate. The mount surface may be configured to be bonded to the electrode pad by means of solder or a conductive paste. FIGs. 1 to 5 exemplify the mount surface 125 as a metal flat surface. Alternatively, the mount surface 125 may include small unevenness or may include the electrode pad.

The mount surface 125 of the surface mounting type may be positioned opposite to the first recess 112 of the base 110. Assuming that the first recess 112 is opened to the upper surface, the mount surface 125 may be positioned in a lower portion of the base 110. In this configuration, when the laser device 1 is mounted on the module substrate (not illustrated), laser light can be applied in a direction crossing a substrate surface of the module substrate. The mount surface 125 is not necessarily disposed as exemplified above, and may be positioned at a different site such as a lateral portion or an upper portion of the base 110 assuming that the first recess 112 is opened to the upper surface.

The laser oscillator 150 may be accommodated in the first recess 112. The lens 130 may be bonded to the base 110 as well as may seal the first recess 112. In a state where the laser oscillator 150 is not mounted, the base 110 and the lens 130 may be separated from each other and the lens 130 may be configured to seal the first recess 112 when bonded to the base 110.

In a planar view, the first recess 112 includes an opening that may have a rectangular shape, or may have a square shape as illustrated in FIG. 3. Planar view means viewing from an opened side of the first recess 112. The opening of the first recess 112 may have any shape in a planar view, such as a polygonal shape, an elliptical shape, an oblong shape, a circular shape, or a shape obtained by combining any of these shapes.

The lens 130 may function to decrease expansion of laser light emitted from the laser oscillator 150. The lens 130 may be a collimator lens. Laser light emitted from the laser oscillator 150 may exit the package 100 through the lens 130.

The lens 130 may affect laser light as described above and may seal the first recess 112 when bonded to the base 110. The first recess 112 thus sealed enables reduced ageing deterioration of the laser oscillator 150 and stable driving of the laser oscillator 150. Furthermore, such a configuration in which the lens 130 seals the first recess 112 achieves a reduction in the number of components in comparison to a configuration including a transparent sealing member and a lens.

As illustrated in FIG. 3, in a planar view, a first region 11 defined by removing a region overlapped with the lens 130 from a region occupied by the upper portion of the base 110 may be larger in area than the lens 130. The first region 11 is hatched in FIG. 3. This configuration exerts the following effects. When the lens 130 is bonded, the base 110 is fixed by a jig and the lens 130 is retained by a retainer. The base 110 includes the mount surface 125 of the surface mounting type, so that the jig is preferably structured to laterally fix the base 110. The jig and the retainer coming closer may interfere with each other. However, in the configuration in which the first region 11 has a large area, the retainer retaining the lens 130 and the jig fixing the base 110 can be distant from each other in the horizontal direction (i.e., a direction along a plane in a planar view). This reduces a risk of interference between the jig and the retainer. Accordingly, the lens 130 can be bonded stably. Furthermore, in the configuration in which the first region 11 has the large area, the first region 11 of the base 110 can be additionally provided with a constituent element other than a lens, such as electrodes 121a to 121d (see FIG. 1).

As illustrated in FIG. 3, the first region 11 may entirely surround an outer circumference of the lens 130 in a planar view. This configuration is less likely to cause interference between the jig and the retainer upon bonding of the lens 130 to enable more stable processing of bonding the lens 130.

The lens 130 may include a side surface that can be gripped in the horizontal direction.

The lens 130 may include a main portion 132 including a curved surface through which laser light passes, and a basal portion 134 provided continuously to the main portion 132. The main portion 132 and the basal portion 134 may be identical in composition and may be configured integrally with each other. The basal portion 134 may include a curved surface or may have a plate shape. In a planar view, the lens 130 may be positioned at the center of the first region 11 whereas the main portion 132 may be deviated from the center of the lens 130. The lens 130 positioned at the center can be bonded more stably. Laser light is emitted from a position (i.e., an emitted position from inside to outside the package 100) which may be deviated from the center of the base 110 in a planar view in accordance with disposition of a constituent element in the first recess 112. However, the main portion 132 is deviated from the center of the lens 130 so that the main portion 132 of the lens 130 can be disposed in accordance with the deviated emitted position of laser light.

In a planar view, the basal portion 134 of the lens 130 may have a rectangular shape, or may have a square shape as illustrated in FIG. 3. The basal portion 134 may have any shape in a planar view, such as a polygonal shape, an elliptical shape, an oblong shape, a circular shape, or a shape obtained by combining any of these shapes.

Furthermore, the lens 130 may be positioned at the center of the first region 11 in a planar view, whereas the laser oscillator 150, a mirror 170, or an optical axis of laser light on the opening may be deviated from the center of the first region 11 in a planar view. Even when the laser oscillator 150, the mirror 170, or the optical axis of laser light on the opening is deviated, the lens 130 disposed at the center can be bonded stably.

Herein, a state where A is positioned at the center of B may mean a state where the center of A is overlapped with the center of B. The center may mean a range including the center and an error of a plane figure in a planar view of a target object. The error may be 5% of a minimum width of the plane figure in a planar view of the target object. The minimum width may mean a width minimized when the plane figure is interposed between two parallel lines.

The laser oscillator 150 may be a semiconductor laser. The laser oscillator 150 has the optical axis that may be directed in the horizontal direction (i.e., a direction along a plane in a planar view).

The first recess 112 (see FIG. 4B) may be equipped with the mirror (corresponding to an optical component) 170 configured to reflect laser light emitted from the laser oscillator 150 in a vertical direction (i.e., a direction along a line of sight in a planar view). The mirror 170 may be a prism mirror. Laser light emitted from inside to outside the package 100 may correspond to laser light reflected by the mirror 170.

The laser oscillator 150 is mounted at a site that may be called a first equipped portion 118a (see FIG. 4B). The mirror 170 is mounted at a site that may be called a second equipped portion 118b (see FIG. 4B).

The first equipped portion 118a and the second equipped portion 118b may interpose a level difference 113 (see FIG. 4B) to allow the first equipped portion 118a to be positioned higher than the second equipped portion 118b. In this configuration, in a case where the laser oscillator 150 is mounted directly on the first equipped portion 118a or with a bonding material interposed therebetween, laser light emitted from the laser oscillator 150 can be applied to be away from a lower end of the mirror 170. This can reduce a waste of laser light. In comparison to a configuration in which the laser oscillator 150 is mounted with use of a stand such as a submount, this configuration can have higher heat radiation from the laser oscillator 150 to the base 110.

The second equipped portion 118b may include an inclined surface inclined from the first equipped portion 118a, and the mirror 170 may be mounted on the inclined surface. This configuration facilitates positioning of the mirror 170 to be mounted. As illustrated in FIG. 4C, the second equipped portion 118b may alternatively include a horizontal surface, and the horizontal surface may be equipped with a mirror 171 such as a prism mirror including an inclined reflection surface.

The base 110 may include electrodes 115a to 115e (see FIG. 3) in addition to the first equipped portion 118a and the second equipped portion 118b, which are disposed in the first recess 112. Any of the electrodes 115a to 115e may be electrically connected to the laser oscillator 150 via a connector such as a bonding wire so as to supply the laser oscillator 150 with drive current. Any of the electrodes 115a to 115e may be equipped with a denoising element (e.g., a Zener diode). Any of the electrodes 115a to 115e may be equipped with an element (e.g., a PD (photo diode)) configured to monitor output power of laser light. Any of the electrodes 115a to 115e may be electrically connected to the element to transmit signals. Any of the electrodes 115a to 115e in the first recess 112 may be electrically connected to the electrodes 121a to 121d (see FIG. 1) disposed outside, via an internal conductor of the base 110.

The base 110 may include second stepped portions 114a and 114b (see FIGs. 3 and 4A) positioned in the first recess 112. The electrodes 115a to 115e may be positioned on the second stepped portions 114a and 114b. In this configuration, any one of the electrodes 115a and 115b and the laser oscillator 150 can be electrically connected to each other with a smaller difference in height to facilitate the connection.

The second stepped portions 114a and 114b may be opposed to interpose the laser oscillator 150 and the mirror 170 in a planar view. The second stepped portions 114a and 114b may be included in a first base 110A (see FIG. 4A) to be described later.

The base 110 may include a first stepped portion 123 (see FIG. 1) where part of the lens 130 is positioned. The first stepped portion 123 may include a side surface 123a facing the lens 130 in each of directions A2 and A3 (corresponding to a first direction, see FIG. 1) nonparallel to an optical axis A1 of the lens 130, and the lens 130 and the side surface 123a may interpose a clearance 201 (see FIGs. 3 and 5). The clearance 201 may be sized to enable positional adjustment in the horizontal direction of the lens 130 upon bonding of the lens 130. In this configuration, when the lens 130 is bonded, the first stepped portion 123 allows rough positioning of the lens 130 and the clearance 201 allows positioning of the optical axis A1 of the lens 130.

The clearance 201 means a clearance positioned between the side surface 123a of the first stepped portion 123 and the lens 130. The clearance 201 is not necessarily occupied by a space and may be provided with a bonding material.

In a planar view, the first stepped portion 123 may have a ring shape to be positioned along the outer circumference of the lens 130. This configuration achieves improved sealability of the first recess 112 by the lens 130. Furthermore, the lens 130 can be positioned and bonded stably.

The base 110 may include second recesses 124a to 124d (see FIG. 1) provided continuously to the clearance 201. The second recesses 124a to 124d may be adjacent to the lens 130. The second recesses 124a to 124d may be opened upward in the base 110. FIG. 1 exemplifies a case where the second recesses 124a to 124d include four recesses. There may alternatively be provided one second recess or two or more second recesses. When there are provided two second recesses, the two second recesses 124a and 124c may face each other to interpose the first recess 112. In this configuration, the retainer for the lens 130 can be inserted to the second recesses 124a to 124d upon bonding of the lens 130. The lens 130 can thus be retained laterally. When there is a single second recess, the lens 130 may be sucked to be retained. When there are two or more second recesses, the lens 130 can be sucked or gripped to be retained. Provision of the second recesses 124a to 124d enables stable processing of aligning the optical axis of the lens 130 upon bonding of the lens 130.

As illustrated in FIG. 5, the lens 130 and the base 110 may be bonded to each other via a bonding material 221. The lens 130 may be glass whereas the bonding material 221 may be solder.

The lens 130 may include a metal film 136 disposed at a site bonded to the base 110. As illustrated in FIG. 3, the metal film 136 may be provided continuously to have a ring shape and entirely surround a bonded portion. The metal film 136 may be a thin film formed with use of a deposition device.

The base 110 may include a metal film 116 disposed at a site bonded to the lens 130. As illustrated in FIG. 3, the metal film 116 may be provided continuously to have a ring shape and entirely surround the bonded portion. The metal film 116 may be a metalized film or a plated metalized film.

This configuration including the metal films 116 and 136 and the bonding material 221 achieves high sealability of the first recess 112 by the lens 130.

Though not illustrated, the metal films 116 and 136 may be positioned to reach the side surface of the first stepped portion 123 and the side surface of the lens 130, and the solder as the bonding material 221 may be positioned to reach the clearance 201. The bonding material 221 bonding the lens 130 and the base 110 may be a resin (e.g., curing adhesive), and the lens 130 may be a resin.

As illustrated in FIG. 2, the base 110 may include the first base 110A including a through-hole 119 and a second base 110B made of a metal and closing one of openings of the through-hole 119. The through-hole 119 having the one of the openings closed by the second base 110B may constitute the first recess 112. The laser oscillator 150 may be mounted on the second base 110B. The mirror 170 may be mounted on the second base 110B. The second base 110B may be made of copper. This configuration achieves improved heat radiation of the laser oscillator 150. Specifically, in a case where the laser oscillator 150 generates heat, the heat of the laser oscillator 150 can be efficiently radiated to the module substrate (not illustrated) via the second base 110B having high thermal conductivity and the mount surface 125 (see FIG. 4A) of the surface mounting type opposing the laser oscillator 150 to interpose the second base 110B.

As illustrated in FIG. 2, the second base 110B may include a protrusion 118 projecting into the first recess 112. The protrusion 118 includes an upper surface that may include the first equipped portion 118a provided with the laser oscillator 150 and the second equipped portion 118b provided with the mirror 170. This configuration achieves a smaller optical path length from the laser oscillator 150 to the lens 130 as well as high heat radiation of the laser oscillator 150. Accordingly, this can decrease expansion of laser light having reached the lens 130.

The first base 110A may be mainly made of an insulating material, and may include one or both of a conductor film and an interlayer via (i.e., conductor) which are disposed on a surface or inside the first base 110A. The first base 110A may have a stacked structure including a plurality of stacked insulating layers. Examples of the insulating material may include a ceramic, glass, and a resin. Each of the conductor film and the interlayer via may be a metalized conductor.

The first base 110A includes a bottom surface (i.e., a surface facing the second base 110B) which may be provided with a conductor film 117 (see FIG. 4A). The conductor film 117 and the second base 110B may be bonded to each other via a bonding material 211 such as a brazing filler material.

### (Embodiment 2)

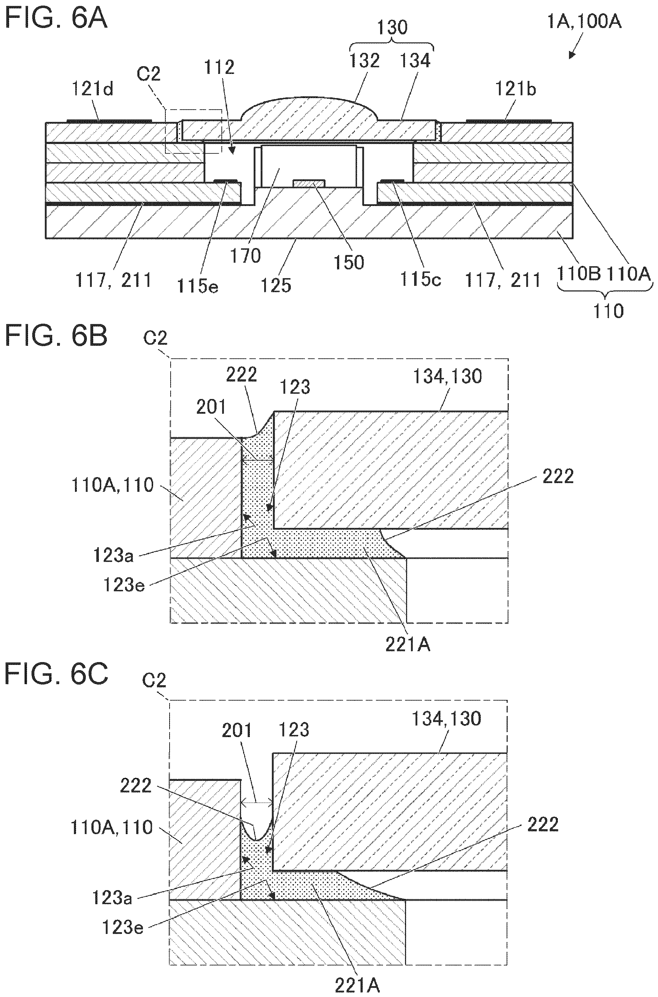

FIG. 6A is a longitudinal sectional view of a laser device and a package equipped with an optical component according to embodiment 2. FIG. 6B is an enlarged view detailing a portion C2 in FIG. 6A according to a first example. FIG. 6C is an enlarged view detailing the portion C2 in FIG. 6A according to a second example. Embodiment 2 provides a laser device 1A and a package (corresponding to a package equipped with an optical component) 100A that may be different in the configuration of the bonded portion between the lens 130 and the base 110 and may be the same or similar in the remaining constituent elements to those according to embodiment 1 or any one of embodiments 3 to 8 to be described later.

The lens 130 and the base 110 are bonded by a bonding material 221A that may be low melting glass as illustrated in FIGs. 6A to 6C. The laser device 1A illustrated in FIG. 6A may be manufactured through the following manufacturing steps. Initially, the first base 110A and the second base 110B are bonded to each other by brazing or the like. This step will be called a first bonding step. Subsequently, the laser oscillator 150 and the mirror 170 are bonded by soldering or the like to the first equipped portion 118a and the second equipped portion 118b, respectively. This step will be called a second bonding step. In a case where an element such as a PD or a Zener diode are equipped, the element is bonded in the second bonding step. Thereafter, wiring connection such as wire bonding is applied to the laser oscillator 150 and the like. Subsequently, the lens 130 is bonded to the base 110. This step will be called a third bonding step. In such manufacturing steps, bonding temperatures in the respective bonding steps may be set in such a manner as "the bonding temperature in the first bonding step > the bonding temperature in the second bonding step > the bonding temperature in the third bonding step". Adoption of low melting glass as the bonding material 221A facilitates setting of the bonding temperatures.

The lens 130 may be glass and the site bonded to the base 110 may be a surface exposing a material for the lens 130.

The base 110 contains an insulating material such as a ceramic, and the site bonded to the lens 130 may be a surface exposing the insulating material.

As illustrated in FIGs. 6B and 6C, the bonding material 221A may be positioned to reach two surfaces (i.e., a lower surface 123e and the side surface 123a) of the first stepped portion 123. Furthermore, the bonding material 221A may be positioned to reach a lower surface and a side surface in an edge portion of the lens 130. The bonding material 221A may be positioned between the base 110 and the lens 130. This configuration achieves a longer path breaking sealing of the first recess 112 (also called a "leakage path") to reduce occurrence of such sealing leakage. As illustrated in FIG. 6B, the bonding material 221A may be in contact with entireties of the lower surface 123e and the side surface 123a of the first stepped portion 123 in at least one longitudinal section. In a longitudinal section at any position of the first stepped portion 123 as well as the single longitudinal section, the bonding material 221A may be in contact with the entireties of the two surfaces. This configuration achieves further reduced occurrence of the sealing leakage.

As illustrated in FIGs. 6B and 6C, the bonding material 221A may include a meniscus (i.e., curved surface) 222 recessed between the base 110 and the lens 130. This configuration achieves improved stress resistance of the bonding material 221A.

### (Embodiment 3)

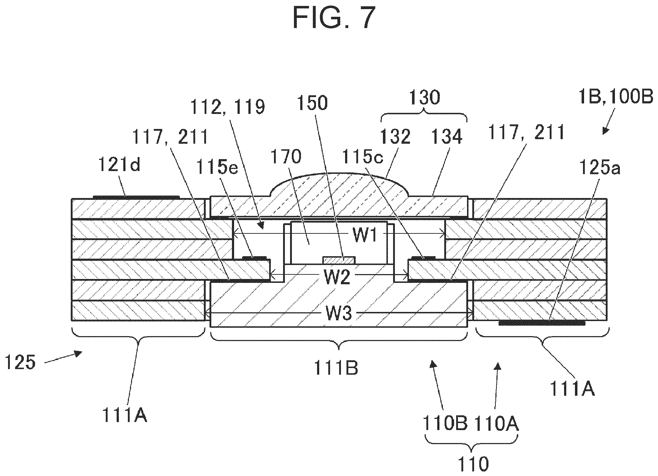

FIG. 7 is a longitudinal sectional view of a laser device and a package equipped with an optical component according to embodiment 3. Embodiment 3 provides a laser device 1B and a package (corresponding to a package equipped with an optical component) 100B that may be different in the configuration around the mount surface 125 and may be the same or similar in the remaining constituent elements to those according to embodiment 1 or 2 or any one of embodiments 4 to 11 to be described later.

The through-hole 119 in the first base 110A may have a shape as illustrated in FIG. 7 in a longitudinal section from a first end to a second end of the through-hole 119. The shape has an intermediate width W2 smallest among widths W1 to W3 of the through-hole 119. The width W1 indicates a width at a site closest to the one of the openings, the width W3 indicates a width at a site closest to the other one of the openings, and the width W2 indicates a width at a site positioned between these two sites.

The first base 110A may include a first bottom surface 111A, the second base 110B may include a second bottom surface 111B, and the first bottom surface 111A and the second bottom surface 111B may be adjacent to each other. In the above longitudinal section, the first base 110A may include two first bottom surfaces 111A, and the two first bottom surfaces 111A may be positioned on respective sides to interpose the second bottom surface 111B. The first bottom surfaces 111A may appear as a single continuous bottom surface when viewed from below, to surround the second bottom surface 111B.

The configurations of the widths W1 to W3 as well as the configurations of the first bottom surface 111A and the second bottom surface 111B may appear not only in the single longitudinal section but also in any directed longitudinal section from the first end to the second end of the through-hole 119.

In this configuration, the mount surface 125 of the surface mounting type can include part of the first base 110A. The first base 110A may include a wiring conductor (i.e., the conductor film and the interlayer via) whereas the first bottom surface 111A may include an electrode 125a. The electrode 125a may be connected to the wiring conductor. This configuration enables transmission and reception of signals or a power source via a surface mounted site.

The second bottom surface 111B may be positioned lower than the first bottom surface 111A. When the first bottom surface 111A includes the electrode 125a, the second bottom surface 111B may be positioned lower than a bottom surface of the electrode 125a. In this configuration, the second bottom surface 111B can be disposed closer to the module substrate (not illustrated) in comparison to the first bottom surface 111A when the first bottom surface 111A and the second bottom surface 111B are mounted on the module substrate. Accordingly, when the first bottom surface 111A and the second bottom surface 111B are bonded to the module substrate, this configuration can achieve improved thermal conductance from the second base 110B to the module substrate and improved heat radiation to the laser oscillator 150. Specifically, an assumed method of bonding to the module substrate will include bonding the first bottom surface 111A and the second bottom surface 111B to the module substrate (or the electrode pad of the module substrate) via solder or a bonding material such as a conductive paste. On this assumption, the difference in height between the second bottom surface 111B and the first bottom surface 111A can achieve a reduced thickness of the bonding material on the second bottom surface 111B and reduced deterioration in thermal conductance due to the bonding material. This achieves improved heat radiation of the laser oscillator 150 by the second base 110B. Alternatively, the second bottom surface 111B may be positioned higher than the first bottom surface 111A. In this case, mountability can be improved in an exemplary case where a conductive adhesive containing a metal filler is used to bond an MCPCB (metal core printed circuit board).

### (Embodiment 4)

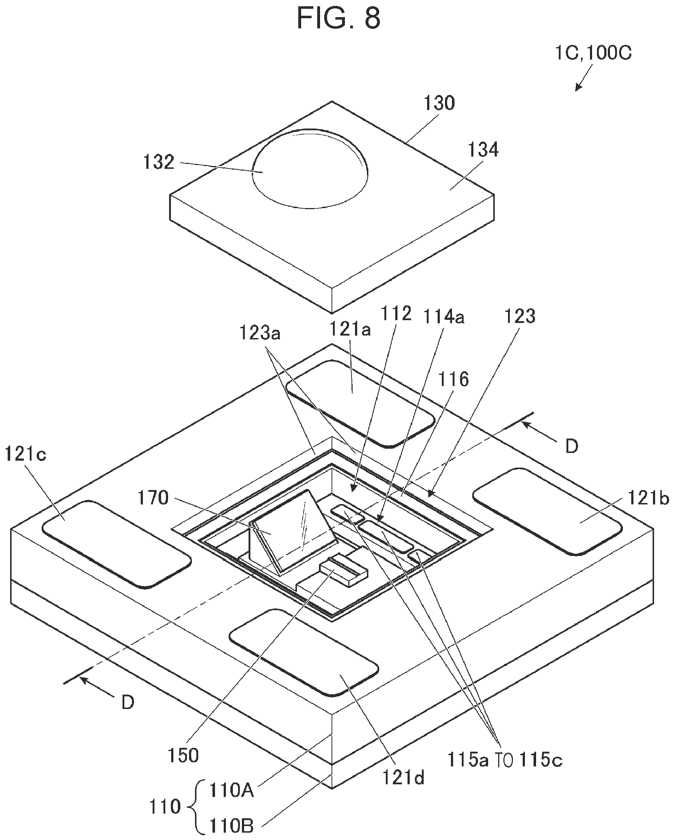

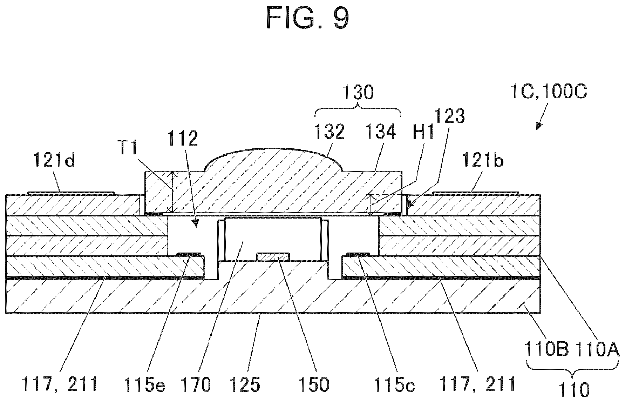

FIG. 8 is a perspective view of a laser device and a package equipped with an optical component according to embodiment 4. FIG. 9 is a sectional view taken along line D-D in FIG. 8. Embodiment 4 provides a laser device 1C and a package (corresponding to a package equipped with an optical component) 100C that may be different in the configurations of the upper portion of the base 110 and part of the lens 130, and may be the same or similar in the remaining constituent elements to those according to any one of embodiments 1 to 3 or any one of embodiments 5 to 9 to be described later.

As illustrated in FIG. 8, the base 110 does not necessarily include the second recesses 124a and 124b (see FIG. 1) exemplified in embodiment 1. This configuration allows the base 110 to be thinned.

As illustrated in FIG. 9, the lens 130 has a thickness T1 of at least a site positioned at the first stepped portion 123, and the thickness T1 may be larger than a height H1 of the first stepped portion 123. In this configuration, the lens 130 projects outward from the first stepped portion 123, and the retainer can retain such a projecting portion upon bonding of the lens 130.

### (Embodiments 5 and 6)

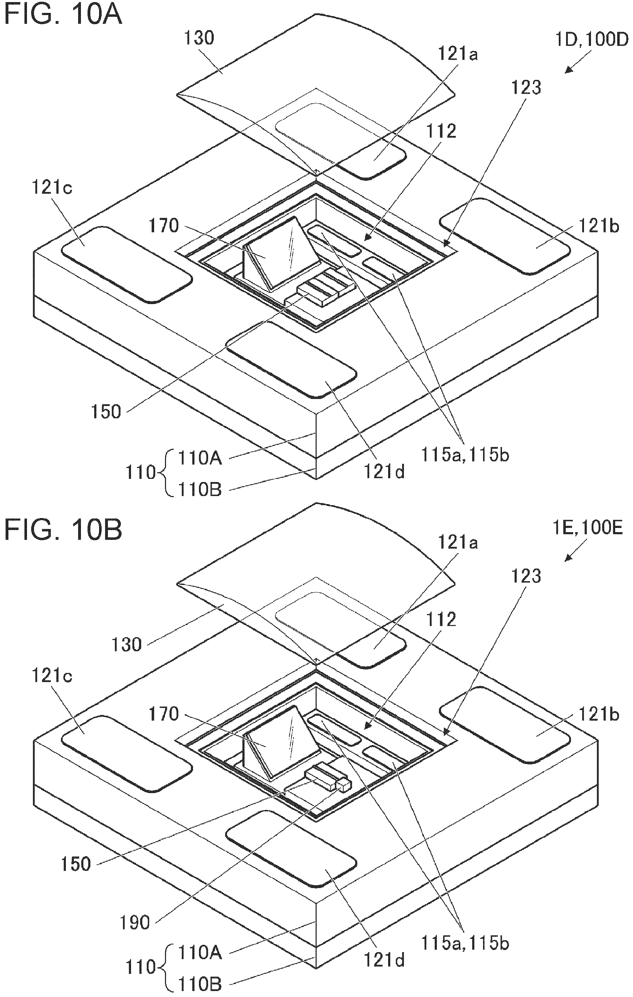

FIG. 10A is a perspective view of a laser device and a package equipped with an optical component according to embodiment 5. FIG. 10B is a perspective view of a laser device and a package equipped with an optical component according to embodiment 6. Embodiment 5 and 6 provide laser devices 1D and 1E and packages (each corresponding to a package equipped with an optical component) 100D and 100E, respectively, which may be different in a configuration of an element in the first recess 112 and may be the same or similar in the remaining constituent elements to those according to any one of embodiments 1 to 4 or embodiment 7 or 8 to be described later.

As in embodiment 5 illustrated in FIG. 10A, the laser oscillator 150 may be of a dual system configured to emit two laser beams. The two laser beams have optical axes that may be parallel to each other at an emitter of the laser oscillator 150 and may be aligned in the horizontal direction.

The lens 130 may be a cylindrical lens, and a center axis of a cylindrical surface of the cylindrical lens may be positioned along an alignment direction of the optical axes of the two laser beams.

As in embodiment 6 illustrated in FIG. 10B, a PD 190 configured to monitor power of laser light may oppose the mirror 170 to interpose the laser oscillator 150. The PD 190 may be mounted on the second base 110B. Laser light from the laser oscillator 150 may partially leak oppositely from a laser light emitting side. The above configuration achieves more accurate monitoring of laser light power through detection of such leakage of the laser light.

### (Embodiments 7 and 8)

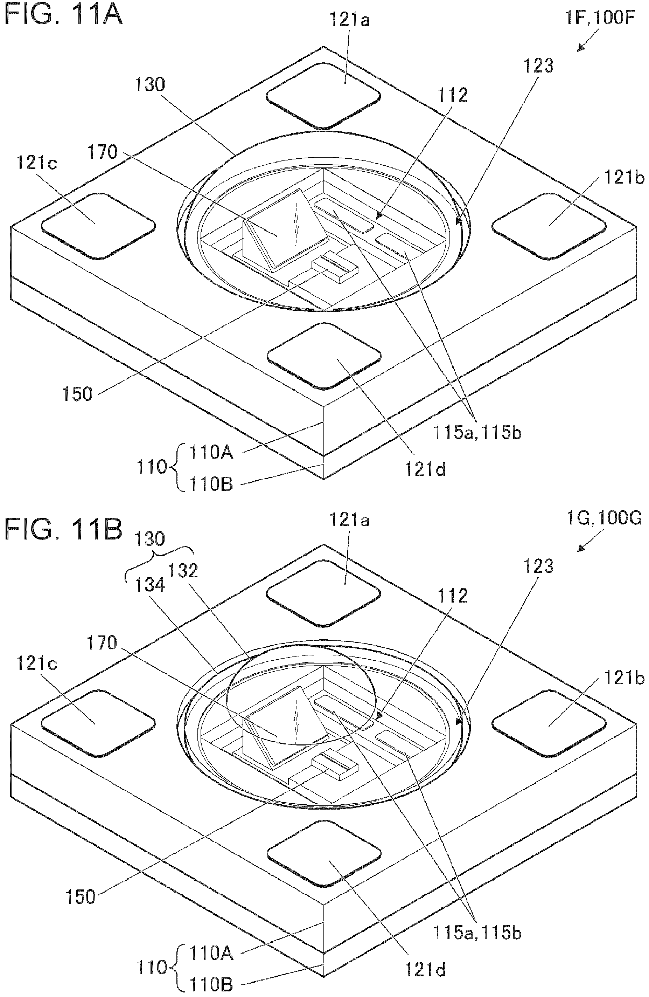

FIG. 11A is a perspective view of a laser device and a package equipped with an optical component according to embodiment 7. FIG. 11B is a perspective view of a laser device and a package equipped with an optical component according to embodiment 8. Embodiments 7 and 8 provide laser devices 1F and 1G and packages (each corresponding to a package equipped with an optical component) 100F and 100G, respectively, which may be different in the shape of the lens 130 and the shape of the bonded portion between the base 110 and the lens 130 and may be the same or similar in the remaining constituent elements to those according to any one of embodiments 1 to 6 or embodiment 9 or 10 to be described later.

As in embodiment 7 illustrated in FIG. 11A, the lens 130 may have a circular shape in a planar view. The lens 130 includes a lens surface (specifically, a curved surface functioning to decrease expansion of laser light) which may be positioned in an entire region in a planar view. The lens surface may be a spherical surface or an aspheric surface.

As in embodiment 8 illustrated in FIG. 11B, the lens 130 may include the main portion 132 and the basal portion 134, and the basal portion 134 may have a circular shape in a planar view. The basal portion 134 may have a disc shape including a side surface.

In embodiments 7 and 8, the first stepped portion 123 of the base 110 may have a circular shape corresponding to a planar shape of the lens 130 in a planar view.

In embodiments 7 and 8, the circular shape may be replaced with an elliptical shape or an oblong shape.

### (Embodiments 9 and 10)

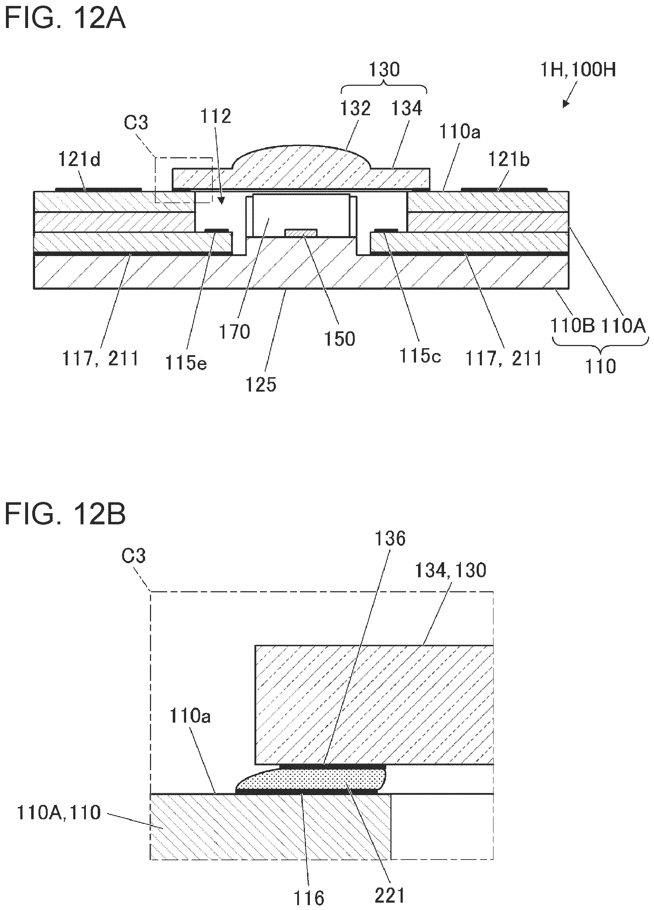

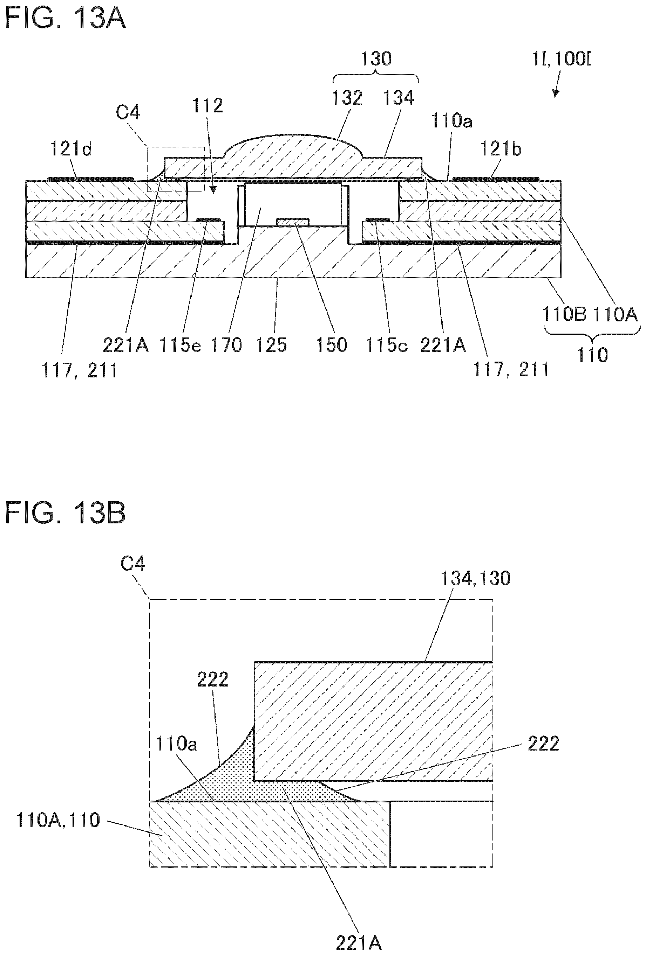

FIG. 12A is a longitudinal sectional view of a laser device and a package equipped with an optical component according to embodiment 9. FIG. 12B is an enlarged view detailing a portion C3 in FIG. 12A. FIG. 13A is a longitudinal sectional view of a laser device and a package equipped with an optical component according to embodiment 10. FIG. 13B is an enlarged view detailing a portion C4 in FIG. 13A. Embodiment 9 and 10 provide laser devices 1H and 11 and packages (each corresponding to a package equipped with an optical component) 100H and 100I, respectively, which may be different in the configuration of the bonded portion between the lens 130 and the base 110 and may be the same or similar in the remaining constituent elements to those according to any one of embodiments 1 to 8.

As in embodiment 9 illustrated in FIG. 12A and embodiment 10 illustrated in FIG. 13A, the base 110 does not necessarily include the first stepped portion 123 (see FIG. 1) exemplified in embodiment 1. The lens 130 may be bonded to the upper surface 110a of the base 110. The bonded portion between the lens 130 and the base 110 may have a ring shape in a planar view to surround the opening of the first recess 112. The base 110 not including the first stepped portion 123 can be reduced in thickness.

In embodiment 9 as illustrated in FIG. 12B, the bonding material 221 may be solder or a conductive paste. The lens 130 may include the metal film 136 disposed at the site bonded to the base 110. The base 110 may include the metal film 116 disposed at the site bonded to the lens 130.

In embodiment 10 as illustrated in FIG. 13B, the bonding material 221A may be low melting glass. The lens 130 may be glass and the site bonded to the base 110 may be a surface exposing the material for the lens 130. The base 110 contains an insulating material such as a ceramic, and the site bonded to the lens 130 may be a surface exposing the insulating material. The bonding material 221A may be positioned to reach the lower surface and the side surface in the edge portion of the lens 130.

Also in the configurations according to embodiments 9 and 10, the lens 130 can exert high sealability of the first recess 112.

In embodiment 10, the bonding material 221A may include the meniscus (i.e., curved surface) 222 recessed between the base 110 and the lens 130. This configuration achieves improved stress resistance of the bonding material 221A.

The embodiments of the present disclosure have been described above. However, in the present disclosure, the laser device and the package equipped with an optical component are not limited to those of the above embodiments. The structures exemplified in the embodiments can be appropriately changed without departing from the purport of the invention.

The following description refers to an embodiment of the present disclosure. In an embodiment,
(1) a laser device includes:
   a package including a base and a lens; and
   a laser oscillator accommodated in the package; in which
   the base includes a first recess and a mount surface of a surface mounting type,
   the laser oscillator is accommodated in the first recess,
   the lens is bonded to the base and seals the first recess, and
   the laser oscillator emits laser light that exits the package through the lens.
(2) In the laser device according to (1) described above,
   in a planar view, a first region defined by removing a region overlapped with the lens from a region occupied by an upper portion of the base is larger in area than the lens.
(3) In the laser device according to (2) described above,
   the first region entirely surrounds an outer circumference of the lens in a planar view.
(4) In the laser device according to (2) or (3) described above,
   the lens includes a main portion including a curved surface through which the laser light passes, and a basal portion provided continuously to the main portion,
   the lens is positioned at a center of the first region in a planar view, and
   the main portion is deviated from a center of the lens in a planar view.
(5) In the laser device according to any one of (2) to (4) described above,
   the lens is positioned at a center of the first region in a planar view, and
   the laser oscillator is deviated from the center of the first region in a planar view.
(6) In the laser device according to any one of (1) to (5) described above,
   the base further includes a first stepped portion where part of the lens is positioned,
   the first stepped portion includes a first side surface facing the lens in a first direction nonparallel to an optical axis direction of the lens, and
   the first side surface and the lens interpose a clearance.
(7) In the laser device according to (6) described above,
   in a planar view, the first stepped portion has a ring shape and is positioned along an outer circumference of the lens.
(8) According to (6) or (7) described above, the laser device further includes
   a bonding material configured to bond the lens and the base, in which
   the bonding material extends from part of a lower surface of the lens to the clearance.
(9) In the laser device according to any one of (6) to (8) described above,
   the base includes a second recess provided continuously to the clearance, and
   the second recess and the lens are adjacent to each other in a planar view.
(10) According to any one of (1) to (9) described above, the laser device further includes
   a bonding material configured to bond the lens and the base, in which
   the bonding material is low melting glass.
(11) According to any one of (1) to (9) described above, the laser device further includes
   a bonding material configured to bond the lens and the base, in which
   the bonding material is solder, and
   the lens includes a metal film disposed at a site bonded to the base.
(12) In the laser device according to any one of (1) to (11) described above,
   the base includes
   a first base including a through-hole, and
   a second base made of a metal and closing one of openings of the through-hole,
   the through-hole including the one of the openings closed by the second base constitutes the first recess, and
   the laser oscillator is mounted on the second base.
(13) In the laser device according to (12) described above,
   the second base includes
   a protrusion projecting into the first recess,
   a first equipped portion positioned on an upper surface of the protrusion and provided with the laser oscillator, and
   a second equipped portion positioned on the upper surface of the protrusion and provided with a mirror.
(14) In the laser device according to (13) described above,
   the second base includes a level difference positioned between the first equipped portion and the second equipped portion and allowing the first equipped portion to be positioned higher than the second equipped portion.
(15) In the laser device according to (13) or (14) described above,
   the second equipped portion includes an inclined surface inclined from the first equipped portion, and
   the mirror is mounted on the inclined surface.
(16) In the laser device according to any one of (13) to (15) described above,
   the first base includes a second stepped portion positioned in the first recess, and an electrode positioned on the second stepped portion.
(17) In the laser device according to any one of (12) to (16) described above,
   the first base includes a first bottom surface,
   the second base includes a second bottom surface,
   the first bottom surface and the second bottom surface are adjacent to each other, and
   the second bottom surface is positioned lower than the first bottom surface.
(18) In the laser device according to any one of (1) to (17) described above,
   the mount surface is positioned opposite to the first recess.

In an embodiment, (19) a package equipped with an optical component, the package includes
a base and a lens, in which
the base includes a first recess and a mount surface of a surface mounting type, and includes an optical component equipped portion disposed in the first recess, and
the lens is configured to seal the first recess when the lens is bonded to the base.

### INDUSTRIAL APPLICABILITY

The present disclosure is applicable to a laser device and a package equipped with an optical component.

### REFERENCE SIGNS

1, 1A to 1I laser device
11 first region
100 package (package equipped with optical component)
110 base
110A first base
110B second base
111A first bottom surface
111B second bottom surface
112 first recess
113 level difference
114a, 114b second stepped portion
115a to 115e electrode
116 metal film
117 conductor film
118 protrusion
118a first equipped portion
118b second equipped portion
119 through-hole
121a to 121d electrode
123 first stepped portion
123a side surface
125 mount surface
130 lens
132 main portion
134 basal portion
A1 optical axis
A2, A3 first direction
150 laser oscillator
170 mirror
190 PD
201 clearance
211, 221, 221A bonding material
222 meniscus
T1 thickness
H1 height
W1 to W3 width

## Claims

1. A laser device comprising:
a package including a base and a lens; and
a laser oscillator accommodated in the package; wherein
the base includes a first recess and a mount surface of a surface mounting type,
the laser oscillator is accommodated in the first recess,
the lens is bonded to the base and seals the first recess, and
the laser oscillator emits laser light that exits the package through the lens.

2. The laser device according to claim 1, wherein
in a planar view, a first region defined by removing a region overlapped with the lens from a region occupied by an upper portion of the base is larger in area than the lens.

3. The laser device according to claim 2, wherein
the first region entirely surrounds an outer circumference of the lens in a planar view.

4. The laser device according to claim 3, wherein
the lens includes a main portion including a curved surface through which the laser light passes, and a basal portion provided continuously to the main portion,
the lens is positioned at a center of the first region in a planar view, and
the main portion is deviated from a center of the lens in a planar view.

5. The laser device according to claim 3, wherein
the lens is positioned at a center of the first region in a planar view, and
the laser oscillator is deviated from the center of the first region in a planar view.

6. The laser device according to claim 1, wherein
the base further includes a first stepped portion where part of the lens is positioned,
the first stepped portion includes a first side surface facing the lens in a first direction nonparallel to an optical axis direction of the lens, and
the first side surface and the lens interpose a clearance.

7. The laser device according to claim 6, wherein
in a planar view, the first stepped portion has a ring shape and is positioned along an outer circumference of the lens.

8. The laser device according to claim 6, the laser device further comprising
a bonding material configured to bond the lens and the base, wherein
the bonding material extends from part of a lower surface of the lens to the clearance.

9. The laser device according to claim 6, wherein
the base includes a second recess provided continuously to the clearance, and
the second recess and the lens are adjacent to each other in a planar view.

10. The laser device according to claim 1, the laser device further comprising
a bonding material configured to bond the lens and the base, wherein
the bonding material is low melting glass.

11. The laser device according to claim 1, the laser device further comprising
a bonding material configured to bond the lens and the base, wherein
the bonding material is solder, and
the lens includes a metal film disposed at a site bonded to the base.

12. The laser device according to claim 1, wherein
the base includes
a first base including a through-hole, and
a second base made of a metal and closing one of openings of the through-hole,
the through-hole including the one of the openings closed by the second base constitutes the first recess, and
the laser oscillator is mounted on the second base.

13. The laser device according to claim 12, wherein
the second base includes
a protrusion projecting into the first recess,
a first equipped portion positioned on an upper surface of the protrusion and provided with the laser oscillator, and
a second equipped portion positioned on the upper surface of the protrusion and provided with a mirror.

14. The laser device according to claim 13, wherein
the second base includes a level difference positioned between the first equipped portion and the second equipped portion and allowing the first equipped portion to be positioned higher than the second equipped portion.

15. The laser device according to claim 13, wherein
the second equipped portion includes an inclined surface inclined from the first equipped portion, and
the mirror is mounted on the inclined surface.

16. The laser device according to claim 13, wherein
the first base includes a second stepped portion positioned in the first recess, and an electrode positioned on the second stepped portion.

17. The laser device according to claim 12, wherein
the first base includes a first bottom surface,
the second base includes a second bottom surface,
the first bottom surface and the second bottom surface are adjacent to each other, and
the second bottom surface is positioned lower than the first bottom surface.

18. The laser device according to claim 1, wherein
the mount surface is positioned opposite to the first recess.

19. A package equipped with an optical component, the package comprising
a base and a lens, wherein
the base includes a first recess and a mount surface of a surface mounting type, and includes an optical component equipped portion disposed in the first recess, and
the lens is configured to seal the first recess when the lens is bonded to the base.
